# FASCICULE DE BREVET EUROPEEN

(11) **EP 1 050 845 B1**
(45) Date de publication et mention de la délivrance du brevet: **03.10.2012**
(21) Numéro de dépôt: 00401128.4
(22) Date de dépôt: 21.04.2000
(51) Int. Cl.: G06K 19/077

(54) **Procédé de montage d'un microcircuit dans une cavité d'une carte**
Verfahren zum Einsetzen eines Microchips in eine Kartenausnehmung
Method for mounting a microchip in a recess of a card

(30) Priorité: 06.05.1999 FR 9905778
(43) Date de publication de la demande: 08.11.2000
(73) Titulaire: Oberthur Technologies, 92300 Levallois-Perret (FR)
(72) Inventeur: Bouchez, François, 14790 Verson (FR); Launay, François, 14610 Epron (FR); Loubly, Pierre, 14000 Caen (FR); Venambre, Jacques, 14123 Ifs (FR)
(74) Mandataire: Santarelli

(56) Documents cités:
- EP-A- 0 331 316
- EP-A- 0 519 564
- DE-A- 19 618 101
- US-A- 5 461 256

## Description

L'invention se rapporte à un procédé de montage d'un microcircuit préalablement monté sur une plaquette de connexion, à l'intérieur d'une cavité préparée à cet effet dans une carte formant support.

L'invention concerne plus particulièrement l'enrobage du microcircuit dans un matériau durcissable du genre résine polymérisable, selon un processus permettant d'augmenter la résistance à la flexion de la carte dans des proportions très importantes.

L'invention concerne également toute carte à microcircuit communément appelée "carte à puce" comportant une particularité de structure résultant de la mise en oeuvre du procédé, comme indiqué plus loin.

Parmi les techniques connues de montage d'un microcircuit dans la cavité d'une carte, l'une des plus couramment utilisées consiste à former d'abord un module constitué d'une plaquette de connexion du type circuit imprimé, à fixer le microcircuit sur cette plaquette et à coller ensuite le module dans une cavité non débouchante réalisée dans la carte. Par cavité non débouchante, on entend une creusure ouverte sur l'une des faces de la carte mais dont la profondeur est inférieure à l'épaisseur de la carte. La cavité a donc un fond constitué par une partie amincie de la carte. Le microcircuit est généralement connecté par soudures filaires aux contacts externes du circuit imprimé. Une résine de protection est ensuite déposée sur le microcircuit avant la mise en place du module dans la cavité.

On a défini une norme ISO permettant de caractériser la résistance de la carte à des contraintes de flexion. Des cycles mécaniques de flexion sont imposés à la carte et celle-ci doit être dépourvue de rupture mécanique ou électrique, après avoir subi un certain nombre de tels cycles de flexion.

La technique de montage indiquée plus haut présente l'inconvénient de concentrer une grande partie des contraintes mécaniques de flexion sur le microcircuit lui-même. On a cherché à déplacer les zones de contrainte extrêmes vers des régions externes au module. Par exemple, on a préconisé de créer des zones d'affaiblissement externes au module, lesquelles peuvent être constituées par des réductions locales d'épaisseur du support ou au contraire par des structures de renforcement appliquées sur le module. Ces méthodes présentent les inconvénients suivants :

On affaiblit la résistance mécanique de la carte en matière plastique dans des zones données, qui peuvent conduire à la rupture de la matière plastique dans ces zones.

La création des zones d'affaiblissement modifie l'aspect visuel de la carte et lui donne un caractère inesthétique. La structure est complexe.

On connaît d'après le document EP - 0 331 316 une technique selon laquelle le volume compris entre le fond de la cavité et le module est occupé par la résine ou par un élément capable d'absorber des chocs. La structure est également complexe.

Une autre technique est décrite dans le document de brevet européen N° 0 519 564 appartenant à la Demanderesse. Selon cette technique, le microcircuit est introduit dans la cavité du support, à la mise en place du module après dépôt dans cette cavité d'une résine de protection qui enrobe le microcircuit et remplit sensiblement tout le volume de la cavité. Par ce moyen, on rigidifie la zone de la carte contenant le microcircuit, ce qui le protège dans une certaine mesure des contraintes mécaniques de flexion.

En outre, une nervure annulaire usinée dans le fond de la cavité permet de confiner la résine, déposée avant le collage, au centre de la cavité. Cette nervure est de préférence discontinue pour permettre à la résine en excès de s'écouler vers les bords de la cavité au moment où on enfonce le microcircuit dans la goutte de résine. Le but visé dans le cadre de cette technique connue est en effet de remplir la plus grande partie de la cavité en évitant tout débordement de résine au moment de la mise en place du module.

Cependant le bloc rigide constitué par le microcircuit et la résine reporte les contraintes mécaniques vers le pourtour de la cavité, plus précisément au voisinage du périmètre de son fond. Au cours de cycles de flexion répétés, on observe que la carte a tendance à se fissurer dans cette zone de faible épaisseur.

De plus, la présence de la nervure annulaire ralentit la cadence d'usinage et empêche de monter des circuits intégrés de grande taille dans une cavité de dimensions données, toutes choses égales par ailleurs. La nervure peut aussi entrer en contact avec les fils reliant le microcircuit aux plages de raccordement, ce qui peut être une cause de rupture des liaisons électriques d'accès au microcircuit.

L'invention propose un perfectionnement à cette technique d'enrobage du microcircuit, permettant notamment de réduire très sensiblement les contraintes de flexion au voisinage de la périphérie du fond de la cavité et de supprimer la nervure de confinement.

Selon un premier aspect de l'invention, on réduit de façon surprenante les contraintes transmises à la périphérie du fond en libérant simplement cette zone de la résine de fixation et d'enrobage du microcircuit.

Plus précisément, l'invention concerne un procédé de montage d'un microcircuit dans une cavité d'une carte formant support, tel que défini par la revendication 1.

De préférence, on utilise une résine thixotrope. On rappelle que la thixotropie est la propriété que possède certains corps visqueux de perdre une partie de leur viscosité sous l'effet d'une agitation ou d'un mouvement rapide en cisaillement. Au repos, le corps retrouve sa viscosité initiale. En utilisant une résine thixotrope à l'état liquide, c'est-à-dire avant son durcissement, on peut la déposer au fond de la cavité (sous forme de goutte(s) ou cordon(s), par exemple), sans qu'elle s'étale, en choisissant convenablement sa viscosité au repos. Au moment du dépôt de la résine, la viscosité diminue rapidement au cours de son expulsion à travers les buses de dosage. Une fois déposée sur le fond de la cavité, elle retrouve sa viscosité initiale élevée, ce qui permet de mieux maîtriser la répartition voulue de la résine, propre à assurer de façon certaine la formation de l'anneau d'air recherché. Une fois la résine étalée après montage du module, elle conserve sa viscosité d'origine et la forme de l'anneau d'air obtenu n'est pas modifiée pendant la polymérisation.

D'autre part, il est avantageux de procéder à un traitement de surface localisé de la zone centrale du fond de la cavité, préalablement au dépôt de la résine. Ce traitement est préférentiellement opéré par l'action d'un faisceau laser. On augmente ainsi l'énergie de surface de la zone centrale de sorte que le fond de la cavité comporte deux zones d'états de surface différents s'étendant toutes deux au-delà de l'emplacement du microcircuit (au centre de la cavité) et sensiblement concentriquement par rapport à cet emplacement. On a constaté que l'étalement de la résine devient alors dépendant des formes, dimensions et états de surface de ces zones.

Plus particulièrement, si la frontière entre la zone centrale traitée et la zone non traitée, périphérique, d'énergie de surface plus faible, coïncide sensiblement avec le bord intérieur souhaité de l'anneau d'air, cette configuration est propre à arrêter l'étalement de la résine au moment du montage du module. Ce confinement de la résine au centre de la cavité permet de garantir une bonne formation de l'anneau d'air recherché. Le comportement de la résine dû à des états de surface différents de zones concentriques du support est décrit en détail dans une autre demande de brevet déposée conjointement par la Demanderesse.

En outre, le traitement de surface de la zone centrale du fond de la cavité améliore l'adhérence de la résine. Celle-ci doit pouvoir polymériser dans des conditions supportables pour les autres constituants. Par exemple, la température de polymérisation doit être inférieure à la température de ramollissement de la matière plastique utilisée, c'est-à-dire entre 50 et 80° selon les matériaux.

A titre d'exemple, de bons résultats ont été obtenus avec une résine époxy isolante de viscosité typique de l'ordre de 2900 cps (centipoises) et un indice de thixotropie de 2,8 (plus précisément, le rapport des viscosités à 5 tours/mn et 50 tours/mn). La polymérisation est obtenue en 48 heures à température ambiante. La dureté de la résine après polymérisation se situe entre 70 et 80 (shore D). La matière plastique constituant le corps de carte dans lequel est défini la cavité est avantageusement un matériau du genre polybutylène-téréphtalate. En réunissant toutes ces caractéristiques, on peut obtenir une carte résistant à plus de 80 000 cycles mécaniques (dans le sens du plus petit côté de la carte) suivant la norme ISO concernée.

D'autres matériaux peuvent être utilisés pour constituer le corps de carte. Si on utilise le polybutylène-téréphtalate mentionné ci-dessus, caractérisé par une faible énergie de surface, le traitement de surface du fond de la cavité est particulièrement recommandé pour obtenir une bonne adhésion de la résine. Ainsi, une amélioration notable de l'adhérence a été obtenue par des traitements de surface tels que le flammage, le traitement Corona ou le traitement Plasma (Ar ou Ar/O₂). Cependant, le traitement par faisceau Laser présente, comme mentionné ci-dessus, l'avantage supplémentaire de pouvoir plus facilement localiser le traitement de surface au centre du fond de la cavité, ce qui permet de bénéficier du phénomène décrit ci-dessus, au moment de l'étalement de la résine et par conséquent, de mieux maîtriser la formation de l'anneau d'air.

Selon une variante, la zone annulaire compressible peut être obtenue en disposant en outre dans ladite cavité un anneau de matériau élastomère, tout autour du matériau d'enrobage. Plus précisément, on peut déposer cet anneau de matériau élastomère le long du pourtour du fond de la cavité avant de disposer la résine, de sorte que, quel que soit l'étalement de celle-ci, la résine est maintenue éloignée du périmètre du fond de la cavité. La formation d'un anneau d'air tout autour du matériau d'enrobage reste la solution préférée, mais on peut aussi envisager une combinaison de ces deux moyens, ladite zone annulaire compressible étant obtenue en agençant côte à côte dans la cavité un anneau d'air et un anneau de matériau élastomère.

La distribution de la résine sur le fond de la cavité a aussi son importance. De préférence, on adoptera une configuration de dépôt de résine déterminée en fonction de la forme de la cavité, notamment la forme du périmètre de son fond et la géométrie du microcircuit considéré.

Par exemple, si le fond de la cavité a un contour au moins approximativement rectangulaire ou ovale, on déposera, de préférence, plusieurs gouttes de résine définissant une configuration sensiblement centrée par rapport au fond de la cavité et approximativement de même forme que celui-ci, de façon que, lors du positionnement du microcircuit dans la cavité, les gouttes se mélangent et s'étalent pour former un anneau d'air le long des parois de la cavité.

Par exemple, pour une cavité rectangulaire, on peut se contenter de déposer deux gouttes sur la paroi de fond, décalées dans le sens de la longueur de ladite cavité, suivant une ligne médiane de celle-ci.

Une autre possibilité consiste à déposer une pluralité de petites gouttes, c'est-à-dire dans la pratique une douzaine ou plus, définissant une configuration approximativement rectangulaire ou sensiblement ovale, allongée dans le sens de la longueur de la cavité rectangulaire ou ovale, respectivement. La quantité de résine déposée au centre de la configuration sera de préférence plus faible que sur les autres parties du fond, pour tenir compte de l'épaisseur du microcircuit.

L'invention concerne aussi une carte selon la revendication 16

L'invention sera mieux comprise et d'autres avantages de celle-ci apparaîtront plus clairement à la lumière de la description qui va suivre d'un procédé de montage d'un microcircuit dans la cavité d'une carte formant support, donnée uniquement à titre d'exemple et faite en référence aux dessins schématiques annexés dans lesquels :
- la figure 1 est une vue partielle en coupe de la carte en matière plastique dans laquelle on a pratiqué une cavité ;
- la figure 2 illustre le dépôt de la résine dans la cavité ;
- la figure 3 est une vue de dessus de la figure 2 ;
- la figure 4 illustre le montage du module dans la cavité ;
- la figure 5 est une coupe V-V de la figure 4 ;
- les figures 6 à 10 illustrent d'autres configurations possibles de dépôt de la résine ; et
- la figure 11 illustre une variante du procédé.

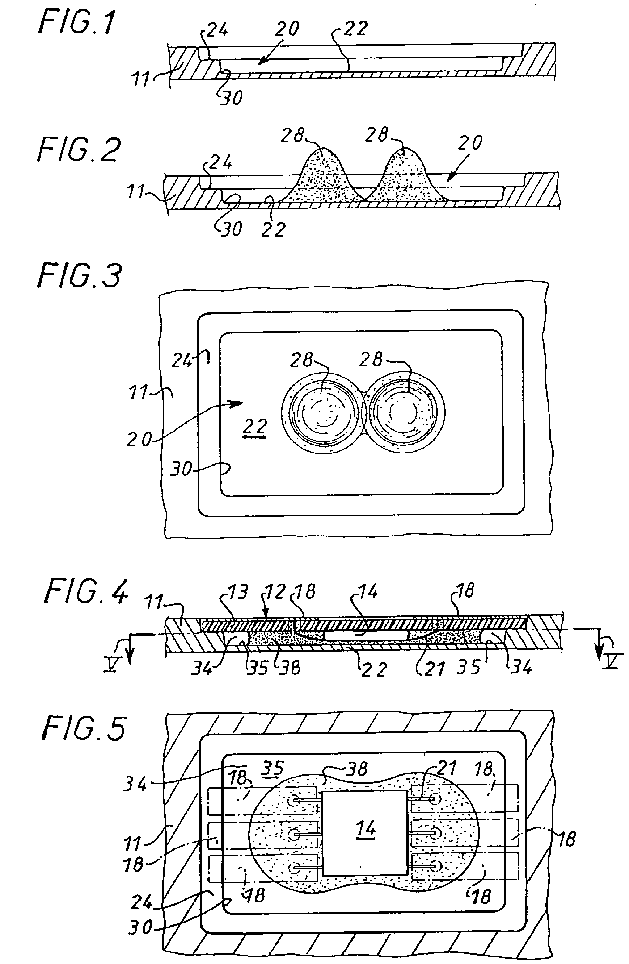

Un procédé de montage d'un microcircuit dans la cavité d'une carte formant support, conforme à l'invention, est illustré sur les figures 1 à 5. Pour la mise en oeuvre du procédé, on part de deux sous-ensembles classiques, à savoir la carte 11 formant support représentée en partie sur la figure 1 et un module 12 constitué d'une plaquette de connexion 13 portant le microcircuit 14. Ce module, connu en soi, apparaît en coupe sur la figure 4. La plaquette 13 forme une sorte de circuit imprimé portant des plages de raccordement métallique 18 sur l'une de ses faces et, fixé sur l'autre face, le microcircuit 14. Les accès de ce microcircuit, disponible sur la face opposée à la face de fixation, sont reliés par des fils conducteurs 21 aux différentes plages de raccordement 18. Les fils traversent pour ce faire des perçages pratiqués dans le circuit imprimé. La fabrication d'un tel module est parfaitement connue et ne sera pas décrite plus en détail.

La carte 11 formant support est une carte en matière plastique qui comporte une cavité 20 ouverte sur l'une de ses faces. Cette cavité est par exemple usinée dans l'épaisseur de la carte de sorte que son fond 22 est constitué par une partie amincie de la carte elle-même. La cavité est à fond plat et le fond 22 est d'épaisseur constante. Cependant, la cavité comporte en outre une zone périphérique peu profonde 24 dont la hauteur correspond à l'épaisseur de la plaquette 13 du module 12 augmentée de l'épaisseur de colle nécessaire pour fixer ledit module sur cette zone périphérique. La structure d'une telle cavité est également connue. L'usinage peut être remplacé par un estampage à chaud. Le procédé est mis en oeuvre à partir d'une telle carte formant support, munie de la cavité qui vient d'être décrite.

Une première étape illustrée à la figure 2 consiste à déposer sur le fond de la cavité un matériau d'enrobage pour le microcircuit 14, par exemple une résine encore liquide. Ce matériau d'enrobage est aussi destiné à solidariser rigidement le microcircuit et la plus grande partie du module au fond 22.

Selon l'exemple, on dépose ici deux gouttes de résine 28 au fond de la cavité. La résine et la matière plastique de la carte sont choisies pour que ladite résine adhère au fond 22 de la cavité.

Comme on le voit sur la figure 3, la cavité 20 a un contour rectangulaire et, d'une manière générale, on distribue la résine sur le fond de la cavité selon une configuration déterminée en fonction de la forme de cette cavité, plus particulièrement en fonction de la forme du périmètre 30 du fond 22.

Dans l'exemple, cette configuration est une des plus simples possible, puisqu'il s'agit du dépôt côte à côte de deux gouttes de résine décalées dans le sens de la longueur de la cavité. Néanmoins, on peut considérer que ces deux gouttes de résine définissent globalement une configuration sensiblement centrée par rapport au fond de la cavité et approximativement de même forme que celui-ci. Autrement dit, si on considère la figure 3, on peut considérer que les deux gouttes décalées définissent une configuration au périmètre approximativement rectangulaire, au centre du fond 22 de ladite cavité, le contour du dépôt de résine et le périmètre 30 du fond étant approximativement homothétiques.

On utilise de préférence une résine thixotrope dont les caractéristiques ont été indiquées plus haut. Il en résulte notamment qu'au moment du dépôt (figure 2) cette résine ne s'étale pas sur le fond de la cavité. Les deux gouttes représentées peuvent être déposées au moyen de seringues, permettant de doser exactement la quantité de résine placée au fond de la cavité.

Cependant, on remarque sur la figure 2, que la quantité de résine au centre de la configuration, est plus faible puisque les deux gouttes 28 espacées se mélangent peu après dépôt, en raison de la thixotropie de la résine. Cette quantité de résine plus faible au milieu de la configuration est avantageuse puisque l'épaisseur du module à cet endroit est augmentée de l'épaisseur du microcircuit.

Après le dépôt de la résine, on peut, de façon connue, déposer une colle sur la zone périphérique peu profonde 24 avant de placer le module 12 dans la cavité, comme illustré à la figure 4.

Selon une caractéristique remarquable de l'invention, le microcircuit 14 se trouve complètement enrobé dans la résine, mais en même temps, on forme dans la cavité une zone annulaire compressible entourant complètement le matériau d'enrobage, c'est-à-dire la résine, mais s'étendant en partie sur une zone périphérique continue 35 (donc annulaire) du fond 22 de la cavité.

Dans l'exemple décrit ci-dessus, la zone annulaire compressible est obtenue en ménageant dans la cavité un anneau d'air 34 qui se forme tout autour du matériau d'enrobage au moment où on vient placer le module 12 dans la cavité 20. La thixotropie de la résine favorise la formation de cet anneau d'air, car ladite résine devient momentanément plus fluide lorsqu'on enfonce le microcircuit 12 et la plaquette 13 dans la résine déposée. Dès que cette opération est terminée, la résine reprend sa viscosité initiale et ne progresse plus vers le bord 30 du fond de la cavité. Ainsi, l'anneau d'air continu, entoure une colonne de résine 38 s'étendant entre le module et le fond et dans laquelle le microcircuit est totalement enrobé, mais cette colonne ne parvient pas jusqu'au bord 30 du fond de la cavité. La quantité de résine à déposer dans la cavité pour obtenir ce résultat peut être déterminée expérimentalement. Il est clair que le volume total de résine doit être sensiblement inférieur à la différence entre le volume de la partie la plus profonde de la cavité 20 et celui dudit microcircuit. La différence entre ces deux volumes permettra d'ajuster le volume de l'anneau d'air 34 et par conséquent la distance entre le bord 30 du fond de la cavité et la colonne de résine.

Une fois le module 12 mis en place de la façon qui vient d'être indiquée, celui-ci est collé à sa périphérie, sur la zone périphérique peu profonde de la cavité et on passe à une phase de polymérisation de la résine, classique, pour faire durcir le matériau d'enrobage constituant ladite colonne 38.

La figure 5 montre la forme de l'anneau d'air 34 que l'on peut obtenir avec une configuration de dépôt de deux gouttes de résine comme illustré sur les figures 2 et 3, les deux gouttes 28, espacées, se mélangeant peu après dépôt.

D'une manière générale, lorsque la cavité a un contour au moins approximativement rectangulaire ou ovale, on déposera plusieurs gouttes de résine définissant une configuration sensiblement centrée par rapport au fond 35 de la cavité et approximativement de même forme que celui-ci.

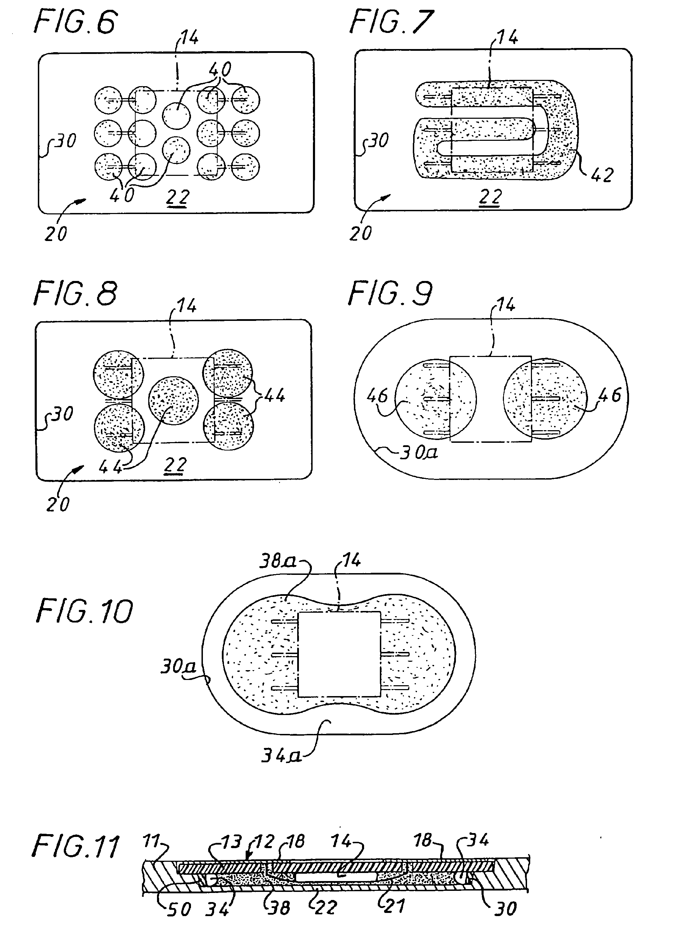

Par exemple, si on considère la figure 6, la configuration en question est constituée par une pluralité de petites gouttes 40 (c'est-à-dire au moins trois, quatorze dans l'exemple) définissant une configuration approximativement rectangulaire allongée dans le sens de la longueur du fond 22 de la cavité rectangulaire. Il est cependant à noter qu'au centre de la configuration, on a déposé seulement deux gouttes 40 au lieu de trois. La quantité de résine est donc plus faible dans cette région centrale, pour tenir compte de l'épaisseur du microcircuit 14.

Sur la figure 7, une autre variante possible consiste à déposer sur le fond de la cavité un ou plusieurs cordons de résine dessinant ladite configuration. Dans l'exemple, on dépose un tel cordon 42 s'enroulant sur lui-même, la forme extérieure de ladite configuration étant globalement semblable à la forme du pourtour 30 de la cavité.

La figure 8 montre un autre exemple possible où ladite configuration est constituée par un petit nombre (5 en l'occurrence) de gouttes de taille moyenne 44. Deux groupes de deux gouttes espacés suivant la direction longitudinale de la cavité encadrent une goutte déposée au centre de celle-ci. Les gouttes sont disjointes.

Les figures 9 et 10 illustrent une configuration possible pour une cavité ovale. Le fond présente donc un périmètre 30a ovale.

Sur la figure 9, on voit que ladite configuration est constituée simplement de deux gouttes 46 disjointes, espacées suivant la direction longitudinale de la cavité ovale.

La figure 10 représente la colonne de résine 38a après mise en place du module dans la cavité et la forme résultante de l'anneau d'air 34a qui se crée à la périphérie de celui-ci.

Dans tous les exemples des figures 6 à 10, on n'a représenté que la partie la plus profonde de la cavité et le bloc en trait fantôme indique la position du microcircuit 14 lorsque le module est installé dans ladite cavité.

La figure 11 illustre une autre variante possible du procédé. Selon cette variante, avant la mise en place du module 12, on dépose, par exemple par tampographie ou sérigraphie, un anneau de matériau élastomère 50 sur le pourtour de la partie la plus profonde de la cavité. Le dépôt est tel que l'élastomère s'étend le long du bord 30 du fond 22 de la cavité et recouvre une zone annulaire périphérique dudit fond. L'anneau d'air est formé de la même façon que précédemment. On a donc agencé côte à côte dans la cavité un anneau d'air 34 et un anneau de matériau élastomère 50, l'ensemble constituant ladite zone annulaire compressible. La présence de cet anneau d'élastomère garantit les dimensions minimum de la zone annulaire compressible que l'on désire créer à la périphérie du fond de la cavité.

Il est important de rappeler que, dans tous les exemples précédemment décrits, la résistance à la flexion est très sensiblement améliorée, avec un tel montage, si la carte est réalisée dans une matière plastique du genre polybutylène-téréphtalate. Ce matériau, à haute performance en flexion, résiste bien aux cycles d'endurance définis par la norme mentionnée ci-dessus et convient particulièrement bien pour réaliser une carte présentant une zone annulaire compressible à la périphérie du fond de la cavité, la carte peut supporter jusqu'à 80000 cycles mécaniques de flexion conforme à la norme, sans rupture de la partie périphérique du fond de la cavité.

Il est en outre à noter que, le volume de l'anneau d'air n'étant pas critique du moment que la résine n'atteint pas le bord du fond, on dispose d'une certaine tolérance dans le dosage du volume de résine utilisée pour enrober et protéger le microcircuit.

Outre le polybutylène-téréphtalate, d'autres matériaux peuvent être utilisés pour constituer la carte formant le support, notamment le PVC, l'acrylonitrile-butadiène-styrène et le polyéthylène-téréphtalate.

## Revendications

1. Procédé de montage d'un microcircuit dans une cavité d'une carte formant support, consistant à former un module (12) constitué d'une plaquette de connexion portant ledit microcircuit (14) et à fixer ce module à ladite carte de façon que ledit microcircuit soit logé dans ladite cavité (20), la fixation du module comportant l'opération consistant à déposer sur le fond de la cavité un matériau (28) adhérant à celui-ci, le microcircuit étant inclus dans ce matériau, et à faire durcir ledit matériau (28, 38), une zone annulaire compressible (34, 50) étant ménagée dans la cavité en entourant complètement ledit matériau (28, 38), cette zone annulaire compressible étant réalisée en ménageant dans ladite cavité un anneau d'air (34), tout autour dudit matériau (28, 38), **caractérisé en ce que** cet anneau s'étend sur une zone périphérique continue (35) du fond (22) de ladite cavité.

2. Procédé de montage selon la revendication 2, **caractérisé en ce qu'**on réalise ladite zone annulaire compressible en agençant côte à côte dans la cavité cet anneau d'air (34) et un anneau de matériau élastomère (50).

3. Procédé de montage selon la revendication 1 ou la revendication 2, **caractérisé en ce qu'**on crée ledit anneau d'air (34) en déposant au fond de la cavité une quantité de résine (28) dont le volume est sensiblement inférieur à la différence entre le volume de la cavité et celui dudit module et **en ce qu'**on met en place ledit module sur la carte de sorte que ledit microcircuit soit logé dans ladite cavité.

4. Procédé selon la revendication 3, **caractérisé en ce qu'**on soumet une zone centrale du fond de la cavité à un traitement de surface par faisceau laser, avant dépôt de la résine.

5. Procédé de montage selon la revendication 3 ou la revendication 4, **caractérisé en ce qu'**on utilise une résine thixotrope.

6. Procédé de montage selon l'une quelconque des revendications précédentes, **caractérisé en ce qu'**on utilise une résine époxy isolante.

7. Procédé de montage selon l'une quelconque des revendications précédentes, **caractérisé en ce qu'**on utilise une résine dont la dureté après polymérisation se situe entre 70 et 80 (shore D).

8. Procédé de montage selon l'une des revendications 3 à 7, **caractérisé en ce qu'**on distribue ladite résine sur le fond de ladite cavité selon une configuration déterminée en fonction de la forme de cette cavité.

9. Procédé de montage selon la revendication 8, **caractérisé en ce que** ladite cavité ayant un contour au moins approximativement rectangulaire ou ovale, on dépose plusieurs gouttes de résine (28, 40, 44, 46) définissant une configuration sensiblement centrée par rapport au fond de la cavité et approximativement de même forme que celui-ci.

10. Procédé de montage selon la revendication 9, **caractérisé en ce qu'**on dépose deux gouttes (28, 46) décalées dans le sens de la longueur de ladite cavité.

11. Procédé de montage selon la revendication 9, **caractérisé en ce qu'**on dépose une pluralité de petites gouttes (40) définissant une configuration allongée dans le sens de la longueur de ladite cavité.

12. Procédé de montage selon la revendication 10 ou la revendication 11, **caractérisé en ce qu'**on dépose une quantité plus faible de résine au centre de ladite configuration.

13. Procédé de montage selon la revendication 8, **caractérisé en ce qu'**on définit ladite configuration en déposant sur le fond de ladite cavité un cordon de résine (42).

14. Procédé de montage selon la revendication 13, **caractérisé en ce qu'**on dépose un tel cordon s'enroulant sur lui-même, la forme extérieure de ladite configuration étant semblable à la forme du pourtour de ladite cavité.

15. Procédé de montage selon l'une des revendications précédentes, **caractérisé en ce que** ladite carte formant support (11) est en matériau plastique du genre polybutylène-téréphtalate.

16. Carte à microcircuit du type comprenant une cavité (20) dans laquelle est logé un module (12) constitué d'une plaquette de connexion portant un tel microcircuit, et comportant une zone annulaire compressible (34, 50) ménagée dans la cavité et comportant un anneau d'air entourant complètement un matériau (38) d'enrobage du microcircuit s'étendant entre le module et le fond de la cavité en solidarisant le module au fond de la cavité, **caractérisée en ce que** l'anneau d'air (34) s'étend sur une zone périphérique (35) continue du fond (22) de ladite cavité.

17. Carte à microcircuit selon la revendication 16, **caractérisée en ce que** le matériau la résine est une résine thixotrope.

18. Carte à microcircuit selon la revendication 16 ou la revendication 17, **caractérisée en ce que** le matériau a une dureté se situant entre 70 et 80 (Shore D).

## Claims

1. Method of mounting a microcircuit in a cavity in a card forming a support, in which method a module (12) consisting of a connecting board carrying said microcircuit (14) is formed and fixed to said card so that said microcircuit is housed in said cavity (20), the fixing of the module including depositing a material that adheres thereto on the bottom of the cavity, the microcircuit being included in this material, and hardening this material (28, 38), a compressible annular area (34, 50) being formed in the cavity, completely surrounding said material (28, 38), this compressible annular area being formed by forming a ring of air (34) in said cavity all around said material (28, 38) **characterised in that** this ring extends over a continuous peripheral area (35) of the bottom (22) of said cavity.

2. Mounting method according to claim 2, **characterised in that** said compressible annular area is formed by arranging this ring of air (34) and a ring of elastomer material (50) side-by-side in said cavity.

3. Mounting method according to claim 1, **characterised in that** said ring of air (34) is created by depositing on the bottom of the cavity a quantity of resin (28) whose volume is significantly less than the difference between the volume of the cavity and the volume of said module and **in that** said module is fitted to said card so that said microcircuit is housed in said cavity.

4. Mounting method according to claim 3, **characterised in that** a central area of the bottom of the cavity is surface-treated by means of a laser beam before depositing the resin.

5. Mounting method according to claim 3 or claim 4, **characterised in that** a thixotropic resin is used.

6. Mounting method according to any one of the preceding claims, **characterised in that** an insulating epoxy resin is used.

7. Mounting method according to any one of the preceding claims, **characterised in that** a resin is used whose hardness after polymerisation is between 70 and 80 (Shore D).

8. Mounting method according to one of claims 3 to 7, **characterised in that** said resin is distributed over the bottom of said cavity in a configuration determined by the shape of this cavity.

9. Mounting method according to claim 8, **characterised in that** said cavity having an at least approximately rectangular or oval contour, a plurality of drops of resin (28, 40, 44, 46) are deposited defining a configuration substantially centred relative to the bottom of the cavity and approximately the same shape as said bottom of said cavity.

10. Mounting method according to claim 9, **characterised in that** two drops (28, 46) offset in the lengthwise direction of said cavity are deposited.

11. Mounting method according to claim 9, **characterised in that** a plurality of small drops (40) are deposited defining a configuration which is elongate in the lengthwise direction of said cavity.

12. Mounting method according to claim 10 or claim 11, **characterised in that** a smaller quantity of resin is deposited at the centre of said configuration.

13. Mounting method according to claim 8, **characterised in that** said configuration is defined by depositing a bead of resin (42) on the bottom of said cavity.

14. Mounting method according to claim 13, **characterised in that** a spiral bead is deposited, the outside shape of said configuration being similar to the shape of the perimeter of said cavity.

15. Mounting method according to one of the preceding claims, **characterised in that** said card forming a support (11) is made from a plastics material of the polybutylene-terephthalate type.

16. Microcircuit card of the type comprising a cavity (20) housing a module (12) consisting of a connecting board carrying such a microcircuit, and comprising a compressible annular area (34, 50) formed in the cavity and comprising a ring of air completely surrounding a material (38) for coating the microcircuit extending between the module and the bottom of the cavity, securing the module to the bottom of the cavity, **characterised in that** the ring of air (34) extends over a continuous peripheral area (35) of the bottom (22) of said cavity.

17. Microcircuit card according to claim 16, **characterised in that** the material of the resin is a thixotropic resin.

18. Microcircuit card according to claim 16 or claim 17, **characterised in that** the material has a hardness of between 70 and 80 (Shore D).

## Patentansprüche

1. Verfahren zum Einsetzen eines Mikrochips in eine Ausnehmung für eine Karte, die einen Träger bildet, das darin besteht, einen Baustein (12) zu bilden, der aus einer Verbindungsplatte besteht, die den Mikrochip (14) trägt, und diesen Baustein derart an der Karte zu befestigen, dass der Mikrochip in der Ausnehmung (20) aufgenommen wird, wobei die Befestigung des Bausteins den Arbeitsvorgang umfasst, der darin besteht, ein Material (28) auf dem Boden der Ausnehmung aufzutragen, das an diesem haftet, wobei der Mikrochip in diesem Material eingeschlossen wird, und das Material, (28, 38) zum Härten zu bringen, wobei ein zusammendrückbarer ringförmiger Bereich (34, 50) in der Ausnehmung eingerichtet wird, indem er das Material (28, 38) vollständig umgibt, wobei dieser zusammendrückbare ringförmige Bereich durch Einrichten eines Luftrings (34) in der Ausnehmung um das gesamte Material (28, 28) herum ausgeführt wird, **dadurch gekennzeichnet, dass** dieser Ring sich über einen ununterbrochenen Umfangsbereich (35) des Bodens (22) der Ausnehmung erstreckt.

2. Verfahren zum Einsetzen nach Anspruch 2, **dadurch gekennzeichnet, dass** der zusammendrückbare ringförmige Bereich ausgeführt wird, indem dieser Luftring (34) und ein Ring (50) aus Elastomermaterial nebeneinander in der Ausnehmung angeordnet werden.

3. Verfahren zum Einsetzen nach Anspruch 1 oder Anspruch 2, **dadurch gekennzeichnet, dass** der Luftring (34) durch Auftragen einer Harzmenge (28), deren Volumen im Wesentlichen kleiner ist als die Differenz zwischen dem Volumen der Ausnehmung und demjenigen des Bausteins, auf dem Boden der Ausnehmung erzeugt wird, und dadurch, dass der Baustein derart auf der Karte angebracht wird, dass der Mikrochip in der Ausnehmung aufgenommen wird.

4. Verfahren nach Anspruch 3, **dadurch gekennzeichnet, dass** der mittlere Bereich des Bodens der Ausnehmung vor dem Auftragen des Harzes einer Laserstrahl-Oberflächenbehandlung unterzogen wird.

5. Verfahren zum Einsetzen nach Anspruch 3 oder Anspruch 4, **dadurch gekennzeichnet, dass** thixotropes Harz verwendet wird.

6. Verfahren zum Einsetzen nach einem der vorhergehenden Ansprüche, **dadurch gekennzeichnet, dass** ein isolierendes Epoxidharz verwendet wird.

7. Verfahren zum Einsetzen nach einem der vorhergehenden Ansprüche, **dadurch gekennzeichnet, dass** ein Harz verwendet wird, dessen Härte nach Polymerisation zwischen 70 und 80 (Shore D) liegt.

8. Verfahren zum Einsetzen nach einem der Ansprüche 3 bis 7, **dadurch gekennzeichnet, dass** das Harz gemäß einer Gestaltung auf dem Boden der Ausnehmung verteilt wird, die in Abhängigkeit von der Form dieser Ausnehmung bestimmt wird.

9. Verfahren zum Einsetzen nach Anspruch 8, **dadurch gekennzeichnet, dass**, da die Ausnehmung eine Außenlinie aufweist, die zumindest ungefähr rechteckig oder oval ist, mehrere Harztropfen (28, 40, 44, 46) aufgetragen werden, die eine in Bezug zum Boden der Ausnehmung im Wesentlichen zentrierte Gestaltung und mit ungefähr derselben Form wie dieser bestimmen.

10. Verfahren zum Einsetzen nach Anspruch 9, **dadurch gekennzeichnet, dass** zwei in der Richtung der Länge der Ausnehmung versetzte Tropfen (28, 46) aufgetragen werden.

11. Verfahren zum Einsetzen nach Anspruch 9, **dadurch gekennzeichnet, dass** mehrere kleine Tropfen (40) aufgetragen werden, die eine in der Richtung der Länge der Ausnehmung längliche Gestaltung bestimmen.

12. Verfahren zum Einsetzen nach Anspruch 10 oder Anspruch 11, **dadurch gekennzeichnet, dass** in der Mitte der Gestaltung eine geringere Menge Harz aufgetragen wird.

13. Verfahren zum Einsetzen nach Anspruch 8, **dadurch gekennzeichnet, dass** die Gestaltung durch Auftragen eines Harzstreifens (42) auf dem Boden der Ausnehmung bestimmt wird.

14. Verfahren zum Einsetzen nach Anspruch 13, **dadurch gekennzeichnet, dass** ein solcher Streifen sich um sich selbst ringelnd aufgetragen wird, wobei die äußere Form der Gestaltung mit der Form des äußeren Umfangs der Ausnehmung ähnlich ist.

15. Verfahren zum Einsetzen nach einem der vorhergehenden Ansprüche, **dadurch gekennzeichnet, dass** die Karte, die einen Träger (11) bildet, aus einem Kunststoffmaterial der Art Polybutylenterephtalat besteht.

16. Mikrochipkarte der Art, die eine Ausnehmung (20) umfasst, in der ein Baustein (12) aufgenommen ist, der aus einer Verbindungsplatte besteht, die einen solchen Mikrochip trägt, und einen ringförmigen zusammendrückbaren Bereich (34, 50) umfasst, der in der Ausnehmung eingerichtet ist, und einen Luftring umfasst, der ein Ummantelungsmaterial (38) des Mikrochips vollständig umgibt, das sich zwischen dem Baustein und dem Boden der Ausnehmung erstreckt, indem es den Baustein fest mit dem Boden der Ausnehmung verbindet, **dadurch gekennzeichnet, dass** der Luftring (34) sich über einen ununterbrochenen Umfangsbereich (35) des Bodens (22) der Ausnehmung erstreckt.

17. Mikrochipkarte nach Anspruch 16, **dadurch gekennzeichnet, dass** das Material des Harzes ein thixotropes Harz ist.

18. Mikrochipkarte nach Anspruch 16 oder Anspruch 17, **dadurch gekennzeichnet, dass** das Material eine Härte aufweist, die zwischen 70 und 80 (Shore D) liegt.
